# EUROPEAN PATENT APPLICATION

(11) **EP 1 079 005 A1**
(43) Date of publication of application: **28.02.2001**
(21) Application number: 99917172.1
(22) Date of filing: 27.04.1999
(51) Int. Cl.: C25D 1/04, H05K 3/18

(54) **DISPERSION-STRENGTHENED ELECTROLYTIC CUPPER FOIL AND METHOD FOR PRODUCING THE SAME**

(30) Priority: 30.04.1998 JP 13612598
(71) Applicant: Mitsui Mining & Smelting Co., Ltd, Tokyo 141-8584 (JP)
(72) Inventor: YOKOTA, Toshiko, Ageo-shi Saitama 362-0025 (JP); TAKAHASHI, Susumu, Hiki-gun Saitama 350-0152 (JP); SAKAI, Hisao, Kitaadachi-gun Saitama 362-0806 (JP); DOBASHI, Makoto, Warabi-shi Saitama 335-0005 (JP); AOKI, Yoshihira, Utsunomiya-shi Tochigi 320-0851 (JP)
(74) Representative: Casalonga, Axel
(86) International application number: JP9902228
(87) International publication number: WO9957341

(57) **Abstract**

The dispersion strengthened electrolytic copper foil according to the present invention is an electrolytic copper foil comprising SnO₂ and Sn, in which copper is present in the form of fine crystal grains and SnO₂ is dispersed in the form of ultrafine particles. Such a dispersion strengthened electrolytic copper foil has a high tensile strength.

Moreover, the electrolyte used in the method according to the present invention can be obtained simply by, for instance, bubbling an electrolyte containing copper ions, sulfate ions and Sn ions by passing an oxygen-containing gas through the electrolyte and therefore, it is easy to carry out the method of the present invention.

## Description

### Technical Field

The present invention relates to an electrolytic copper foil and a method for preparing the same and more particularly to a dispersion strengthened electrolytic copper foil useful as a material for preparing a printed circuit board as well as a method for preparing the copper foil.

### Background Art

Up to now, there have been prepared a variety of electrolytic copper foils exhibiting characteristic properties depending on various applications by variously changing, for instance, compositions of electrolytes, conditions for electrolysis and kinds of additives and there have still been developed methods for preparing electrolytic copper foils having various compositions, textures and characteristic properties.

Accordingly, it is an object of the present invention to provide a dispersion strengthened electrolytic copper foil possessing a novel composition and a texture.

### Disclosure of the Invention

The inventors of this invention have conducted various studies of, for instance, compositions, textures and characteristic properties of electrolytic copper foils, have found that if SnO₂ is dispersed in an electrolytic copper foil in the form of ultrafine particles, the copper is also present in the form of fine crystalline grains and this in turn permits the formation of a dispersion strengthened electrolytic copper foil having high tensile strength and that such an electrolytic copper foil can be prepared by carrying out electrolysis of an electrolyte for producing electrolytic copper foils in the presence of ultrafine powder of SnO₂ and have thus completed the present invention.

More specifically, the dispersion strengthened electrolytic copper foil according to the present invention is an electrolytic copper foil comprising SnO₂ and Sn and the copper foil is characterized in that the copper is present as fine crystal grains and the SnO₂ is dispersed therein in the form of ultrafine particles.

In addition, the method for preparing a dispersion strengthened electrolytic copper foil according to the present invention is characterized in that an electrolytic copper foil is prepared using an electrolyte for preparing electrolytic copper foils, which comprises copper ions, sulfate ions, Sn ions and SnO₂ ultrafine particles.

### Brief Description of the Drawings

Fig. 1 shows Sn3d_{5/2} and O1s spectra observed, at various thicknesses in the direction of the depth, in the ESCA analysis of an electrolytic copper foil according to the present invention.
Fig. 2 shows the results of the ESCA observation, which are converted into the Sn concentration and the O concentration present in the electrolytic copper foil, and plotted as functions of the thicknesses in the direction of the depth of the foil or the sputtering time. More specifically, Fig. 2(A) shows the Sn concentration distribution in the electrolytic copper foil and Fig. 2(B) shows the results of the determination of the O concentration in the copper foil.
Fig. 3 shows the results obtained by the TEM observation of an electrolytic copper foil free of any additive. More specifically, Fig. 3(A) shows a bright field image and Fig. 3(B) shows an electron diffraction pattern.
Fig. 4 shows the results obtained by the TEM observation of an electrolytic copper foil according to the present invention. More specifically, Fig. 4(A) shows a bright field image and Fig. 4(B) shows an electron diffraction pattern.
Fig. 5 shows the particle size of SnO₂ particles present in an electrolytic copper foil according to the present invention and the particle size distribution thereof, wherein these results are obtained by high resolution TEM observation.
Fig. 6 shows further magnified SnO₂ particles present in an electrolytic copper foil according to the present invention, wherein these results are obtained by high resolution TEM observation.
Figs. 7 show the results obtained by elementarily analyzing an electrolytic copper foil according to the EDX spectroscopy. More specifically, Figs. 7(A) and 7(B) show the results obtained by elementarily analyzing a cluster portion (the portion A in Fig. 6) according to the EDX spectroscopy and those obtained by elementarily analyzing portions (the portion B in Fig. 6) other than the SnO₂ portions according to the EDX spectroscopy, respectively.
Fig. 8 shows the results observed when elementarily analyzing the precipitates obtained by blowing air through an electrolyte according to the EDX spectroscopy.

### Best Mode for Carrying Out the Invention

The dispersion strengthened electrolytic copper foil according to the present invention will be described in more detail below.

The dispersion strengthened electrolytic copper foil according to the present invention comprises both SnO₂ and Sn. The SnO₂ is dispersed in the entire electrolytic copper foil in the form of ultrafine particles, preferably uniformly throughout the whole electrolytic copper foil and it would contribute to the improvement of the tensile strength of the copper foil. For instance, it can increase the tensile strength of the electrolytic copper foil by about 20%. The ultrafine particles of SnO₂ are present in the form of, for instance, smooth discrete particles having an elliptical shape and a size on the order of about 2 to 5 nm or in the form of clusters each comprising several such single particles. On the other hand, it would be recognized that Sn is present in the electrolytic copper foil, but there are detected neither fine particles nor ultrafine particle of Sn therein. Therefore, it would be concluded that Sn is co-precipitated with copper and occluded in copper in the form of a solid solution. Moreover, copper is present in the form of fine crystal grains, for instance, those having a grain size ranging from 1 to 2 µm and such fine crystal grains would contribute to the improvement of the tensile strength of the electrolytic copper foil. The tensile strength of the dispersion strengthened electrolytic copper foil of the present invention is not less than 40 kgf/mm² and optionally riot less than 70 kgf/mm², depending on the conditions for preparing the same such as the size of SnO₂ ultrafine particles, the content of SnO₂ and the size of copper fine crystal grains.

In the dispersion strengthened electrolytic copper foil of the present invention, the use of SnO₂ and Sn in an extremely small total amount in the electrolytic copper foil would have a tendency to result in insufficient tensile strength-improving effects due to the SnO₂ dispersion and due to the reduction in the size of the copper fine crystal grains, while the use of these components in a large amount adversely affects characteristic properties of the electrolytic copper foil. For this reason, the total amount of SnO₂ and Sn preferably ranges from 40 to 1.1 × 10⁴ ppm as expressed in terms of the amount of Sn. Moreover, if the total amount of SnO₂ and Sn is appropriate, but the amount of SnO₂ is too small, the resulting copper foil is liable to have insufficient tensile strength-improving effects due to the SnO₂ dispersion and due to the reduction in the size of the copper fine crystal grains. Therefore, the weight ratio of SnO₂ to Sn, SnO₂ : Sn, preferably ranges from 5:5 to 9:1.

As has been discussed above, copper is present in the form of fine crystal grains in the dispersion strengthened electrolytic copper foil according to the present invention, while SnO₂ is dispersed in the foil in the form of ultrafine particles. Accordingly, the resulting electrolytic copper foil has high tensile strength.

Then the method for preparing the dispersion strengthened electrolytic copper foil according to the present invention will be described below.

The electrolyte used in the production method of the present invention is an electrolyte for preparing electrolytic copper foils, which comprises copper ions, sulfate ions, Sn ions and SnO₂ ultrafine particles. Such an electrolyte may be prepared by adding SnO₂ ultrafine particles to an electrolyte containing copper ions, sulfate ions and Sn ions to thus give a dispersion or by forming SnO₂ ultrafine particles in an electrolyte containing copper ions, sulfate ions and Sn ions. For instance, the electrolyte usable in the invention is one obtained by bubbling or blowing an oxygen-containing gas through an electrolyte which is commonly used in the production of electrolytic copper foils and contains copper sulfate (CuSO₄ ·5H₂O) and sulfuric acid (H₂SO₄) as principal components and tin sulfate (SnSO₄) to thus form SnO₂ ultrafine particles in the electrolyte.

The oxygen-containing gas used for the bubbling may be pure oxygen, air rich in oxygen or air per se, but a satisfactory effect can be accomplished by using air. Therefore, air is preferably used from the economical standpoint. In addition, it is sufficient, as the bubbling treatment, to bubble the electrolyte by simply passing, through the electrolyte, an oxygen-containing gas injected through small holes.

Sn ions present in the electrolyte are oxidized to form SnO₂ ultrafine particles by such a bubbling treatment using an oxygen-containing gas. The ultrafine particles of SnO₂ exist in the form of, for instance, smooth discrete particles having an elliptical shape and a size on the order of about 2 to 5 nm or in the form of clusters each comprising a plurality of such single particles assembled together.

The electrolyte used in the production method according to the present invention may comprise organic additives which are commonly added to the electrolyte for preparing electrolytic copper foils. Examples of such organic additives are polyethers. The concentration of these polyethers ranges from about 0.001 to 0.1 g/dm³. If the electrolyte includes a polyether in a concentration falling within the foregoing range, the resulting electrolytic copper foil has improved tensile strength. Preferably used as the polyether is polyethylene glycol having a molecular weight preferably ranging from 400 to 20000. In the method for preparing an electrolytic copper foil according to the present invention, it is also possible to use glue, gelatin or constituents thereof.

The following are preferred concentration ranges for every components of the electrolyte used in the production method of the present invention:

| | |
|---|---|
| Cu⁺⁺ | 38 to 90 g/dm³ |
| SO₄⁻⁻ (free sulfate ion concentration) | 29 to 196 g/dm³ |
| SnO₂ ultrafine particles | 0.1 to 6 g/dm³ |
| Sn⁺⁺ | 0.1 to 6 g/dm³ |
| organic additives | 0.001 to 0.1 g/dm³ |

More specifically, the electrolytes used in the production method of the present invention are preferably those having the following compositions:

| | |
|---|---|
| CuSO₄·5H₂O | 150 to 350 g/dm³ |
| H₂SO₄ | 30 to 200 g/dm³ |
| SnO₂ ultrafine particles | 0.1 to 6 g/dm³ |
| SnSO₄ | 0.3 to 15 g/dm³ |
| polyether | 0.001 to 0.1 g/dm³ |

As has been described above, the practice of the method of the present invention is easy since the electrolyte used in the method can be obtained by simply passing an oxygen-containing gas through an electrolyte which comprises, for instance, copper ions, sulfate ions and Sn ions.

The present invention will further be described with reference to the following Examples.

An electrolyte containing CuSO₄·5H₂O, H₂SO₄ and SnSO₄ was bubbled with air to form an electrolyte containing 250 g/dm² of CuSO₄·5H₂O, 50 g/dm² of H₂SO₄, 3 g/dm² of SnO₂ ultrafine particles and 10 g/dm² of SnSO₄. All of these reagents used were extra grade reagents available from Wako Pure Chemical Co., Ltd. The resulting electrolyte was electrolyzed under the following conditions: a bath temperature of 50°C; a current density of 10 A/dm²; and a quantity of electricity of 95 C/cm², using a Ti plate as a cathode and an insoluble anode provided thereon with a surface layer of iridium oxide as an anode. The electrolytic copper foil thus prepared had a tensile strength of 45 kgf/mm² at its ordinary state.

The concentration distribution of the added elements present in the resulting electrolytic copper foil and their oxidized states were determined or observed by the X-ray photo-electron spectroscopy (ESCA; ESCA-K1 available from Shimadzu Corporation). The X-ray source used therein was A1K α (excitation voltage: 10 kV; current 10 mA), the degree of vacuum of the sample chamber was 2 to 5 × 10⁻⁷ Pa, and the analytical area of the sample was 0.85 mm as expressed in terms of its diameter. In this connection, the analysis of the sample in the direction of the depth was carried out while sputtering the sample with Ar⁺ ions (excitation voltage: 2 kV).

A sample for observing with an electron microscope was prepared by punching out a piece of 3mm⌀ from the electrolytic copper foil with a disk punch and then treating the piece with a twin jet controlled potential electropolishing device (Tenupol-3 available from STRUERS Company). The electrolyte used herein comprised 0.25 dm³ of phosphoric acid, 0.25 dm³ of ethanol, 0.05 dm³ of n-propanol, 5 g of urea and 0.5 dm³ of distilled water and the electropolishing was carried out at an electrolyte temperature of 10 °C and an electric voltage of 10 V. The thin film-like sample was further treated by Ar⁺ ion-sputtering (acceleration voltage: 3 kV; sample current: 1 mA; angle of incidence of 11°) for 10 minutes, for the cleaning of the sample surface, using an ion thinning device (600N Duomill available from GATEN Company).

The observation by a transmission electron microscope (TEM: H9000-NAR available from Hitachi, Ltd.) was carried out at an acceleration voltage of 300 kV and the elemental analysis of each sample was performed for an analysis time of 100 to 200 seconds using an energy dispersive X-ray spectroscopic device (EDX: KEVEX △1 SUPER Type available from KEVEX Company) (beam diameter: 3 to 5 nm) fitted to the TEM.

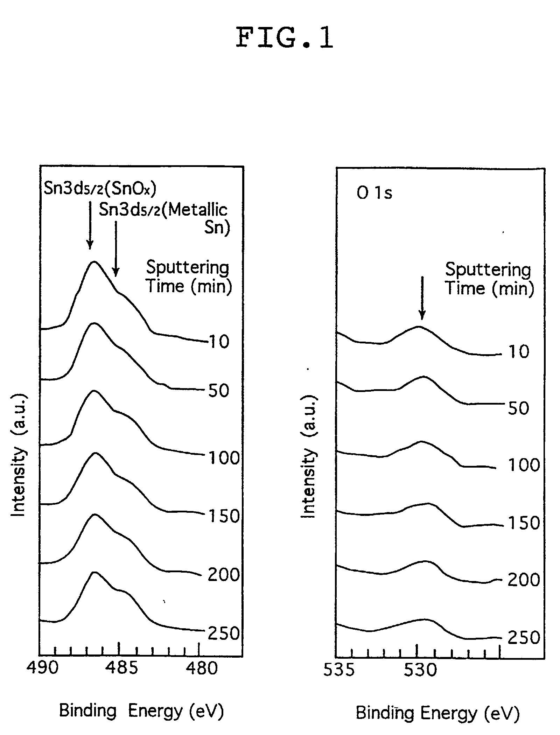

The Sn3d_{5/2} and O1s spectra observed for the foregoing electrolytic copper foil are shown in Fig. 1 wherein the spectra are plotted versus the thickness of the foil in the direction of the depth (i.e., as a function of the sputtering time). In this respect, the rate of sputtering was found to be about 0.05 nm·s⁻¹ (3 nm/min) as expressed in terms of the amount of Cr. The peaks of tin oxide (snO₂) and the elemental tin (Sn) are observed at substantial intensities throughout the entire direction of the depth and the spectra indicate that Sn is incorporated into the foil in the form of both the elemental and oxidized states. The areas of these Sn3d_{5/2} peaks have a tendency to slightly decrease with the depth from the sample surface, but are almost constant in the interior of the electrolytic copper foil. In addition, the O1s peaks are also observed throughout the entire direction of the depth and the peak areas thereof show a depth direction-dependency similar to that observed for Sn. In this regard, the ratio of the Sn in the oxidized state to the Sn in the elemental state as determined by peak-separation of the Sn peak strength was found to be about 68:32 for a sputtering time of 10 minutes and 63:37 for a sputtering time of 250 minutes. The results indicate that not less than about 60% of the Sn content in the electrolytic copper foil is incorporated into the copper foil in the form of the oxide.

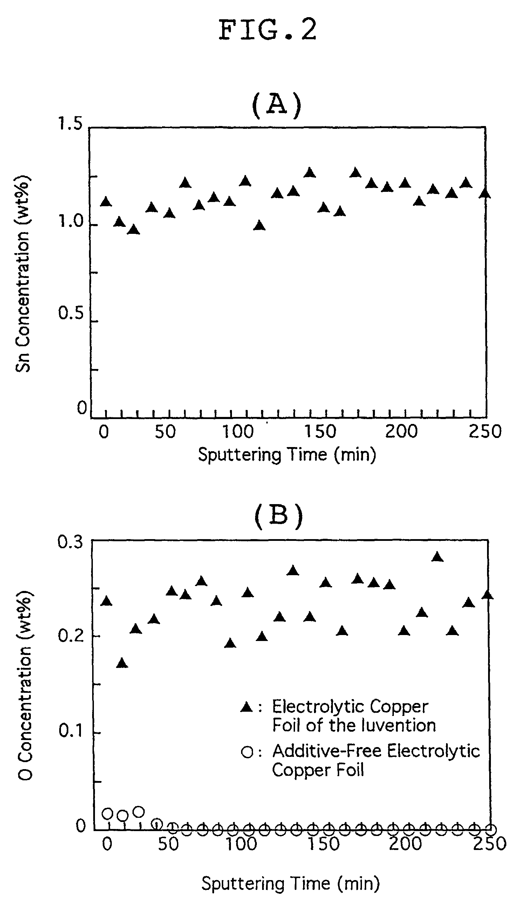

The results of the ESCA observation described above are converted into the Sn concentration and O concentration in the electrolytic copper foil and shown in Fig. 2 in which the concentrations are plotted versus various thicknesses in the depth-direction of the copper foil or as a function of the sputtering time. Fig. 2(A) shows the concentration distribution of Sn in the copper foil and this indicates that the amount of co-precipitated Sn is approximately constant or falls within the range of from 1.0 to 1.3% by weight and that Sn is distributed at a uniform concentration in the copper foil. Fig. 2(B) shows the results of the measured O concentration in the copper foil. The results shown in this figure indicate that the O concentration is also uniformly distributed or falls within the range of from 0.18 to 0.28% by weight and the concentration level thereof indicates that the higher the Sn concentration, the greater the amount of incorporated oxygen. On the other hand, Fig. 2(B) shows the O concentration observed for the additive-free electrolytic copper foil, but the trace amount of O observed in the proximity of the surface is considered to be those formed through surface oxidation and the O concentration observed when the sputtering time exceeds 50 minutes was found to be less than the detection limit.

It has been reported that the rates of sputtering are 88 nm/min for Cu and 121.7 nm/min for Sn as representative values and it has been known that the evaporation rate of Sn is higher than that of Cu by about 38%. However, the Sn content in the foregoing electrolytic copper foil is quite low and no more than about 1% by weight and therefore, we concluded that the content might not be affected by the sputtering rate.

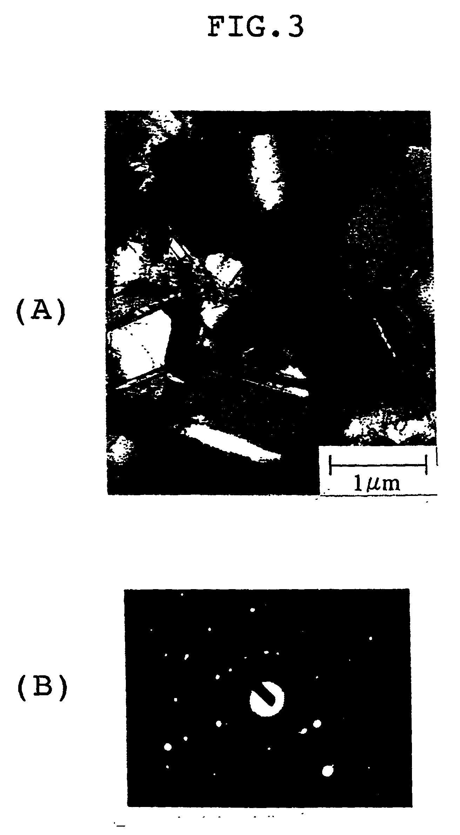

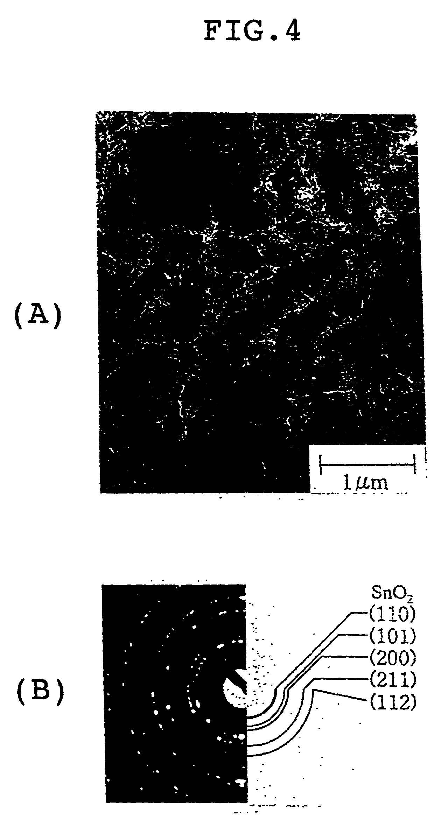

The results of TEM observation of the foregoing additive-free electrolytic copper foil are shown in Fig. 3 and those obtained by the TEM observation of the foregoing electrolytic copper foil are shown in Fig. 4. The bright field images shown in Fig. 3(A) indicate that the size of the crystal grains of the additive-free electrolytic copper foil is distributed over the range of from 0.3 to 4 µm. It can be explained such that the copper foil completely has a Cu type (Al type) face-centered cubic structure (fcc) of elemental copper in the light of the electron diffraction pattern (hereinafter referred to as "EDP") of the additive-free electrolytic copper foil as shown in Fig. 3(B). On the other hand, the size of the crystal grains of the foregoing electrolytic copper foil is distributed over the range of from 0.15 to 2 µm as will be seen from the bright field images shown in Fig. 4(A) and is clearly reduced as compared with that of the additive-free electrolytic copper foil. This aspect can be seen from the results or the EDP as shown in Fig. 4(B) and more specifically, the fcc diffraction pattern which is forming a ring-like pattern. Moreover, the results, i.e., the EDP as shown in Fig. 4(B) also show the presence of a plurality of quite weak additional ring-like patterns other than those for elemental copper. These diffraction rings were analyzed with reference to the results of the ESCA measurement and as a result, it was found that they were originated from tetragonal SnO₂ grains having a rutile type (C4 type) structure.

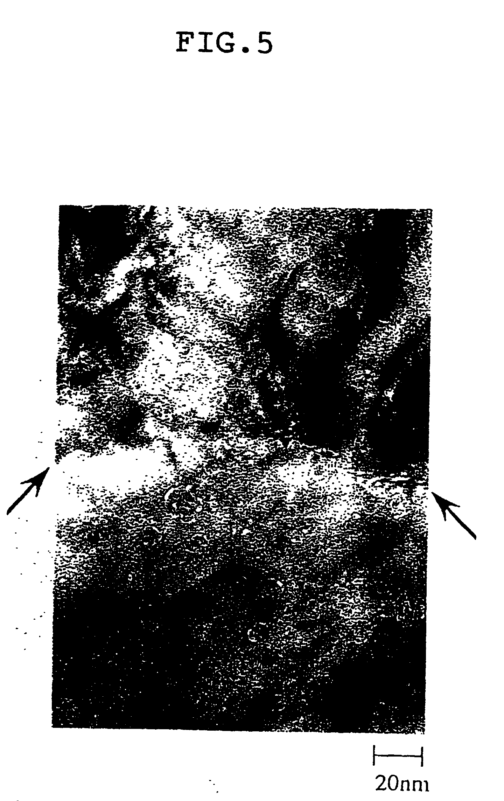

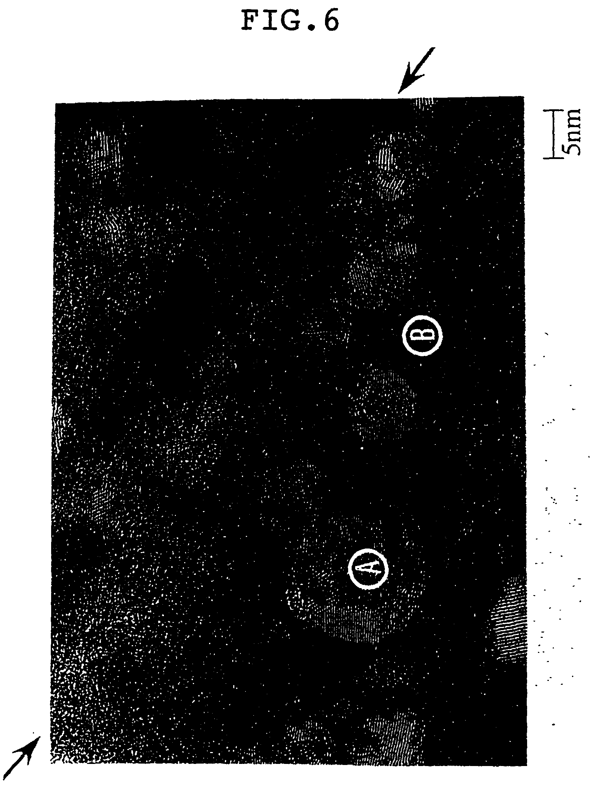

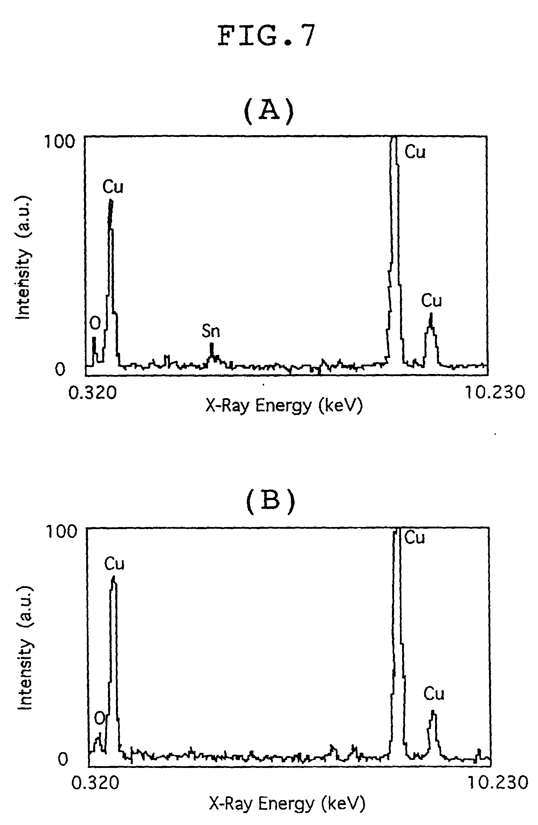

The size of SnO₂ grains in the foregoing electrolytic copper foil and the distributed state thereof were determined or examined by the observation by a high resolution TEM. The results thus obtained are shown in Fig. 5. An arrow in Fig. 5 points at the grain boundary. In the electrolytic copper foil, the SnO₂ particles are almost uniformly distributed in the grain boundary and in the grains and there was not observed any local and uneven distribution in particular regions. Fig. 6 shows further magnified these grains. An arrow in Fig. 6 points at the grain boundary. There are observed distinct striped lattice patterns for SnO₂ particles and this indicates that most of these particles are formed from several single particles assembled together (hereinafter referred to as "clusters"). Each single particle has a size ranging from 2 to 5 nm and a smooth elliptical shape, while there were observed some clusters each having a size of at highest 20 nm. Fig. 7(A) shows the results obtained by elementarily analyzing these cluster portions (the portion A in Fig. 6) and there were confirmed the presence of Sn and O as elements other than copper. On the other hand, the results of the EDX analysis of the portion other than the SnO₂ portions (the portion B in Fig. 6), as shown in Fig. 7(B), indicate that a trace amount of O is detected in addition to copper, the trace O being assumed to be incorporated into the electrolytic copper foil during electrodeposition.

The observed results as described above clearly indicate that, in the electrolytic copper foil prepared from an electrolyte containing SnO₂ and Sn, Sn is incorporated into the copper foil in both the elemental state and an oxide (SnO₂). Regarding these SnO₂ grains, ultrafine particles of SnO₂ are formed, in advance, in the electrolytic cell and accordingly, they are adsorbed on the electrolytic copper foil during the electrolysis individually or after formation of clusters and then incorporated into the copper foil with the elapse of electrolysis time.

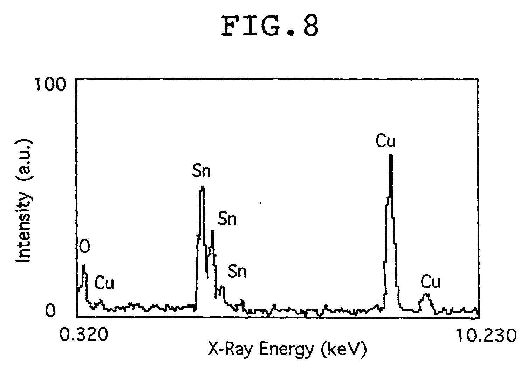

Incidentally, if an electrolyte containing CuSO₄·5H₂O, H₂SO₄ and SnSO₄ was bubbled with air, the electrolyte slightly got cloudy. Thus, the cloudy electrolyte was treated by a centrifugal separator (for 20 minutes at a rotational speed of 4000 rpm) to thus separate yellowish white precipitates. A small amount of the foregoing precipitates settled on the bottom of the test tube was received on a microgrid, followed by washing with ethanol and then drying to give a sample for the TEM observation. The size of a single particle obtained by the TEM observation is found to be about 2 to 5 nm as determined from the striped lattice pattern, which is in good agreement with that estimated from the results shown in Fig. 6 and this clearly indicates that a large number of SnO₂ particles are formed in the electrolyte. It was found that the EDP of these particles showed ring-like patterns and this was caused due to the rutile structure of SnO₂. In addition, the results of the EDX analysis as shown in Fig. 8 indicate that the elements constituting the particles are Sn and O except for Cu detected on the microgrid and this fact is in good agreement with the results of EDP. It would thus be concluded, from the foregoing results, that the ultrafine particles of SnO₂ present in the electrolyte are incorporated into the resulting electrolytic copper foil during the electrolysis.

### Industrial Applicability

The dispersion strengthened electrolytic copper foil according to the present invention is useful in the production of, for instance, printed circuit boards.

## Claims

1. A dispersion strengthened electrolytic copper foil which comprises SnO₂ and Sn, the copper foil being characterized in that copper is present in the form of fine crystal grains and that SnO₂ is dispersed in the form of ultrafine particles.

2. The dispersion strengthened electrolytic copper foil of claim 1 wherein the total amount of SnO₂ and Sn present in the electrolytic copper foil ranges from 40 to 1.1 × 10⁴ ppm as expressed in terms of the amount of Sn.

3. The dispersion strengthened electrolytic copper foil of claim 1 or 2 wherein the weight ratio of SnO₂ to Sn, SnO₂ : Sn, in the electrolytic copper foil ranges from 5:5 to 9:1.

4. A method for preparing a dispersion strengthened electrolytic copper foil comprising the step of preparing an electrolytic copper foil using an electrolyte for electrolytic copper foil-preparation, which comprises copper ions, sulfate ions, Sn ions and SnO₂ ultrafine particles.

5. A method for preparing a dispersion strengthened electrolytic copper foil comprising the steps of bubbling an electrolyte containing copper ions, sulfate ions and Sn ions by passing an oxygen-containing gas through the electrolyte to form SnO₂ ultrafine particles in the electrolyte and then preparing an electrolytic copper foil using the electrolyte for electrolytic copper foil-preparation thus prepared.

6. The method for preparing a dispersion strengthened electrolytic copper foil according to claim 4 or 5 wherein the electrolyte further comprises an organic additive used in electrolytes for electrolytic copper foil-preparation.
